# DEMANDE DE BREVET EUROPEEN

(11) **EP 3 530 784 A1**
(43) Date de publication de la demande: **28.08.2019**
(21) Numéro de dépôt: 19158901.9
(22) Date de dépôt: 22.02.2019
(51) Int. Cl.: D03D 3/00, A41D 1/00

(54) **RUBAN TEXTILE CONDUCTEUR**

(30) Priorité: 22.02.2018 FR 1851518
(71) Demandeur: Satab, 43240 Saint Just Malmont (FR)
(72) Inventeur: MAURIN, Jean-Marc, 43240 Saint Just Malmont (FR)
(74) Mandataire: Lavoix

(57) **Abrégé**

Ce ruban textile conducteur (1) comprend une partie textile (3) s'étendant selon un axe longitudinal (X) et sur une largeur (L) donnée, et au moins un conducteur électrique intégré et tissé dans la partie textile (3) et s'étendant selon l'axe longitudinal (X). La partie textile (3) comporte au moins deux régions (A, B) dont l'armure est différenciée, une première région (A) présentant une première armure étant située sur une première partie de la largeur (L) du ruban (1), et contenant le conducteur électrique, et une seconde région (B) présentant une seconde armure étant située sur une seconde partie de la largeur (L) du ruban (1), et ne contenant aucun conducteur électrique.

## Description

La présente invention concerne un ruban textile conducteur.

Il existe dans le domaine de l'habillement et de l'équipement des techniques de « vêtement connectés » utilisant divers composants électroniques et connexions intégrés dans des tissus. Ces techniques nécessitent de faire passer des conducteurs dans les tissus. Cela est généralement fait en insérant des câbles électriques gainés d'isolant dans des doublures ou des endroits prévus à cet effet. Des nappes intégrant des fils de cuivre sont également connues.

GB 906 671 décrit un ruban ayant une partie textile dans lequel des conducteurs sont intégrés, la partie textile étant tissée d'une seule armure et formant des tubes accueillant les conducteurs.

WO 2015/174135 décrit un ruban comportant une partie textile tissée d'une seule armure et dans laquelle sont tissés des fils conducteurs.

Le but de l'invention est de proposer un ruban textile conducteur s'intégrant de façon pratique et esthétique dans des pièces de vêtement ou d'équipement.

A cet effet, l'invention concerne un ruban textile conducteur comprenant :
- une partie textile s'étendant selon un axe longitudinal et sur une largeur donnée,
- au moins un conducteur électrique intégré et tissé dans la partie textile et s'étendant selon l'axe longitudinal.

Ce ruban textile conducteur est caractérisé en ce que la partie textile comporte au moins deux régions dont l'armure est différenciée, une première région présentant une première armure étant située sur une première partie de la largeur du ruban, et contenant le conducteur électrique, et une seconde région présentant une seconde armure étant située sur une seconde partie de la largeur du ruban, et ne contenant aucun conducteur électrique.

Grâce à l'invention, on distingue sur le ruban une zone électrique, correspondant à la première région, comprenant le ou les conducteurs intégrés dans le ruban, et une zone de couture, correspondant à la seconde région, dans laquelle il est aisé d'intervenir pour la confection d'un vêtement ou d'une pièce d'équipement sans risque de détérioration des conducteurs électriques.

Selon des aspects avantageux mais non obligatoires de l'invention, un tel ruban textile conducteur peut incorporer une ou plusieurs des caractéristiques suivantes, prises dans toute combinaison techniquement admissible :
- La seconde région s'étend sur une largeur d'au moins 8 mm et est située d'un ou de deux côtés de la première région.
- La première région comporte au moins un fil de chaîne superposé au conducteur, ce fil étant d'une couleur contrastante par rapport à une couleur de la partie textile.
- Le ruban textile conducteur comprend au moins un fil de chaîne de codage, rendu visible ou masqué de façon alternative de manière à créer un code d'identification, ce fil de chaîne étant contrastant par rapport à la couleur de la partie textile.
- Le code d'identification est constitué d'une série d'un nombre prédéfini de points formés par les parties visibles du fil de chaîne de codage.
- Au moins une série de points indique un intervalle de conductivité ou résistivité.
- Au moins une série de points indique une information sur une application électrique à laquelle le ruban textile conducteur est destiné.
- Le fil de chaîne de codage est localisé le long d'un bord latéral du ruban situé dans la seconde région.
- Le fil de chaîne de codage de couleur contrastante forme un code sur une face du ruban.
- Le conducteur comprend une torsade de multi-filaments de cuivre argenté.
- Le conducteur électrique forme des boucles ressortant localement et ponctuellement de la partie textile de manière à le rendre accessible hors de la partie textile.
- Le ruban textile conducteur comprend au moins deux conducteurs électriques, et les boucles formées par ces deux conducteurs ressortant de la partie textile sont décalées selon l'axe longitudinal.

L'invention sera mieux comprise et d'autres avantages de celle-ci apparaitront plus clairement dans la description qui va suivre d'un ruban textile conducteur conforme à son principe, faite à titre d'exemple non limitatif en référence aux dessins annexés dans lesquels :
- la figure 1 est une vue à plat d'un ruban conforme à l'invention;
- la figure 2 est une coupe transversale selon le plan II du ruban de la figure 1.
- la figure 3 est une vue à plat d'un ruban conforme à un second mode de réalisation de l'invention.

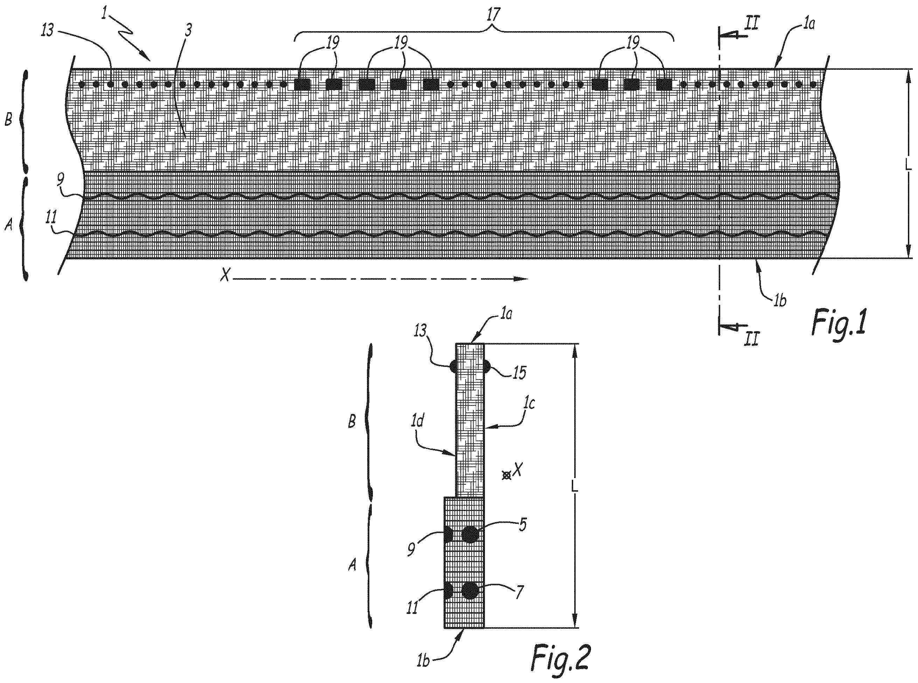

Les figures 1 et 2 représentent un ruban textile 1, comprenant une partie textile 3 s'étendant selon un axe longitudinal X et sur une largeur donnée L. Par « textile » on entend que cette partie est constituée d'un matériau fait d'entrecroisements de fils. Il peut s'agir d'un matériau tissé.

Le ruban 1 comprend également au moins un conducteur électrique intégré dans la partie textile 3 et s'étendant selon l'axe longitudinal X. Le conducteur est orienté dans le sens longitudinal du ruban 1 et permet donc de conduire un courant électrique entre les deux extrémités du ruban 1. Dans l'exemple représenté, le ruban 1 comprend deux conducteurs 5 et 7, visibles sur la coupe de la figure 2.

Selon un mode de réalisation optionnel, chaque conducteur, ou au moins un des conducteurs 5 et 7, peut comprend une torsade de multi-filaments de cuivre argenté. Cette technologie garantit au ruban textile conducteur 1 une souplesse satisfaisante pour l'usage dans la confection de produits textiles.

Les conducteurs 5 et 7 sont enserrés dans le matériau textile, notamment tissés comme des fils de chaîne du matériau textile, de sorte qu'ils font partie intégrante du ruban 1. Ils ne sont pas glissés dans un fourreau, et ne sont pas mobiles en translation longitudinale ou transversale par rapport à la partie textile 3.

La partie textile 3 comporte au moins deux régions A et B dont l'armure est différenciée. Une première région A présentant une première armure est située sur une première partie de la largeur L du ruban 1 et contient les conducteurs électrique 5 et 7. Une seconde région B présentant une seconde armure est située sur une seconde partie de la largeur L du ruban 1 et ne contient aucun conducteur électrique. Par armure, on entend un motif de tissage, qui détermine les caractéristiques d'entrecroisement des fils formant le tissu. L'armure confère au tissu des caractéristiques visuelles identifiables, un « grain » spécifique qui permet de distinguer visuellement et au toucher deux types de tissages différents.

A titre d'exemple, la première région A peut présenter une armure choisie parmi les armures « reps », « cannelé de 2 », etc. A titre d'exemple, la deuxième région B peut présenter une armure choisie parmi les armures « toile », « taffetas », etc.

Dans l'exemple, l'armure de la région A présente une épaisseur de tissage supérieure à l'épaisseur de tissage de la région B.

Ainsi, un fabricant de vêtement ou d'équipement peut facilement distinguer les deux régions A et B du ruban 1 et observer que la couture sera possible dans la région B, sans risquer de blesser les conducteurs 5 et 7.

A titre d'exemple, la seconde région B peut s'étendre sur une largeur d'au moins 8 mm. Cette valeur permet de garantir une largeur suffisante de partie textile 3 pour réaliser les coutures du ruban 1 sur une autre pièce textile.

La partie textile 3 comporte des fils de chaîne orientés longitudinalement, c'est-à-dire selon l'axe X, et des fils de trame orientés transversalement, c'est-à-dire perpendiculairement à l'axe X. Selon un aspect optionnel, la première région A comporte au moins un fil de chaîne superposé au conducteur, ce fil étant d'une couleur contrastante par rapport à une couleur de la partie textile 3, c'est-à-dire à la couleur des fils de trame et des autres fils de chaîne formant la première région A. Cela permet de repérer visuellement le cheminement des conducteurs 5 et 7 à travers le tissu, car les conducteurs étant entourés de fils sur la majeure portion de leur longueur, ceux-ci ne sont pas visibles de l'extérieur du ruban 1. Dans l'exemple, le ruban 1 comprend deux fils de chaîne contrastants 9 et 11 permettant de repérer la position des conducteurs 5 et 7. Cela permet également de connaître le nombre de conducteurs présents dans le ruban 1.

Les fils de chaîne contrastants 9 et 11 peuvent être de couleurs différentes.

Les fils de chaîne 9 et 11 de couleurs contrastantes sont prévus sur au moins une des faces 1c et 1d du ruban 1. En variante non représentée, ces fils peuvent être visibles sur les deux faces 1c et 1d du ruban 1.

De façon optionnelle, le ruban 1 comprend au moins un fil de chaîne 13 de codage rendu visible, ou masqué de façon alternative, de manière à créer un code d'identification 17, ce fil de chaîne 13 étant contrastant par rapport à la couleur de la partie textile 3.

Le code d'identification 17 est constitué d'une série d'un nombre prédéfini de points 19 formés par des parties visibles du fil de chaîne 13. Par exemple, le ruban 1 comporte une série de cinq points 19 puis une série de trois points 19. Entre ces séries, le fil de chaîne de codage 13 est rendu visible à intervalles réguliers dans un tissage intégré à la partie textile 3 et formant des points de taille inférieure à celle des points 19.

En variante non représentée, le fil de codage 13 peut être rendu visible uniquement au niveau des points de codage 19.

Le code d'identification 17 peut être utilisé pour présenter des informations concernant notamment les caractéristiques électriques du ou des conducteurs intégrés dans la partie textile 3, telles que par exemple sa conductivité ou sa résistivité. Les nombres et séries de points 19 peuvent indiquer des intervalles de valeurs de conductivité ou résistivité. Les nombres et séries de points 19 peuvent également consister en une information sur l'application technique à laquelle le ou les conducteurs sont destinés (par exemple, réduction de l'électricité statique, transmission de données, alimentation électrique, conduction de chaleur, etc.).

Chaque série de points 19 peut être liée à une information. Au moins une série de points 19 peut par exemple indiquer le début du code d'identification, dénotant un sens de lecture, et une autre série indiquer un code de produit à visée logistique.

Le fil de chaîne de codage 13 peut être localisé le long d'un bord latéral du ruban 1. Dans le cas présent, le fil 13 est localisé du côté d'un bord 1a du ruban 1. Avantageusement, le fil 13 est prévu sur la seconde région B, de manière à être masqué lors de la couture du ruban 1 sur une pièce textile.

Le fil de chaîne de codage est prévu sur la face 1d du ruban 1. Dans l'exemple, le ruban 1 comprend un fil de chaine de codage 13 visible sur les deux faces 1c et 1d du ruban 1, mais lisible en codage uniquement sur la face 1d, des parties 15 visibles sur la face 1c ne formant pas de code.

Le ruban 1 peut comprendre plus d'un fil de chaîne de codage, par exemple plusieurs fils de codage de couleurs différentes formant des codes d'identification par couleurs indiquant différentes plages de valeurs de caractéristiques électriques.

Selon un mode de réalisation non représenté, la première région A, dite électrique, et la seconde région B destinée à la couture peuvent être localisées différemment. La région B peut notamment être divisée en deux parties localisées de part et d'autre de la région A, c'est-à-dire sur deux côtés de la région A, au lien d'un seul côté sur l'exemple représenté. La région A peut être centrée ou décentrée par rapport à la largeur L du ruban textile conducteur 1.

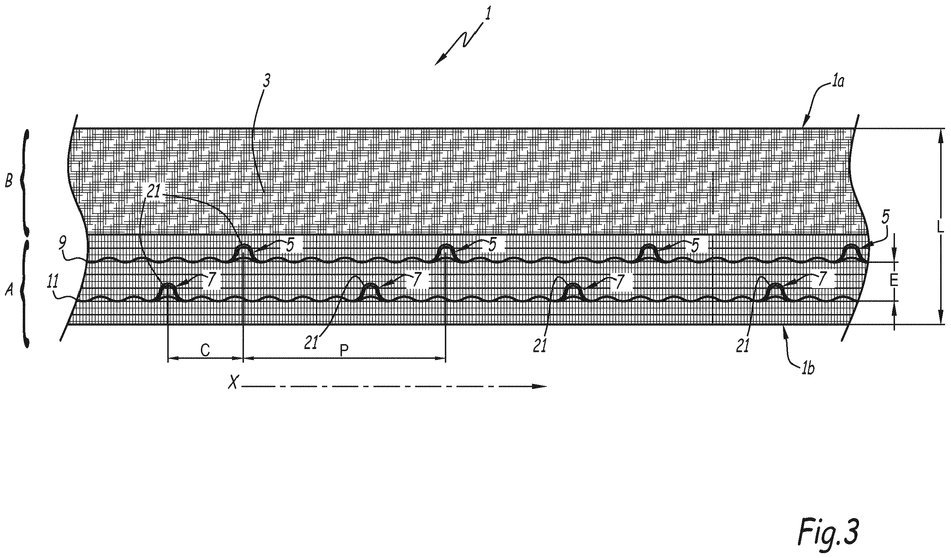

Un second mode de réalisation de l'invention est représenté sur la figure 3. Dans ce mode de réalisation, les éléments communs au mode de réalisation des figures 1 et 2 portent les mêmes références et fonctionnent de la même manière.

Selon ce mode de réalisation, au moins l'un des conducteurs électriques 5 et 7 du ruban 1 peut ressortir localement et ponctuellement de la partie textile 3 pour former des boucles 21 permettant de faire apparaître et de rendre accessibles les conducteurs 5 et 7 hors de la partie textile 3. Ces boucles 21 permettent de réaliser des travaux électriques sur les conducteurs 5 et 7, par exemple de souder des composants électriques, notamment par exemple, des LEDs, des capteurs.

Les boucles 21 ressortant de la partie textile 3 peuvent être prévues selon un pas P, pris dans le sens longitudinal X du ruban 1, qui peut être variable. Le pas P peut être compris, par exemple, entre 5 mm et 2 m.

Chacun des deux conducteurs 5 et 9 peut présenter des boucles 21 ressortant de la partie textile 3, ces boucles 21 étant de préférence décalées selon le sens longitudinal du ruban 1 selon une distance C. La distance C peut être, par exemple, comprise entre 5 mm et 2 m.

Les boucles 21 sont de préférence prévues sur la face 1d du ruban 1, c'est-à-dire la face sur laquelle sont présents les fils contrastants 9 et 11 et sur laquelle le code formé par le fil de codage 13 peut être lu.

Les boucles 21 sont réalisées lors du tissage des conducteurs 5 et 7 avec la partie textile 3, en prévoyant un motif intégrant les valeurs de pas P et la distance C.

Les conducteurs 5 et 7 peuvent être prévus dans la partie textile 3 selon un écartement E, pris perpendiculairement à l'axe longitudinal X, compris entre 2 mm et la largeur L du ruban 1.Les caractéristiques des modes de réalisation et variantes décrits ci-dessus peuvent être combinées pour former de nouveaux modes de réalisation de l'invention.

## Revendications

1. Ruban textile conducteur (1) comprenant :
- une partie textile (3) s'étendant selon un axe longitudinal (X) et sur une largeur (L) donnée,
- au moins un conducteur électrique (5, 7) intégré et tissé dans la partie textile (3) et s'étendant selon l'axe longitudinal (X),
**caractérisé en ce que** la partie textile (3) comporte au moins deux régions (A, B) dont l'armure est différenciée, une première région (A) présentant une première armure étant située sur une première partie de la largeur (L) du ruban (1), et contenant le conducteur électrique (5, 7), et une seconde région (B) présentant une seconde armure étant située sur une seconde partie de la largeur (L) du ruban (1), et ne contenant aucun conducteur électrique.

2. Ruban textile conducteur selon la revendication 1, **caractérisé en ce que** la seconde région (B) s'étend sur une largeur d'au moins 8 mm et est située d'un ou de deux côtés de la première région (A).

3. Ruban textile conducteur selon l'une des revendications précédentes, **caractérisé en ce que** la première région (A) comporte au moins un fil de chaîne (9, 11) superposé au conducteur (5, 7), ce fil (9, 11) étant d'une couleur contrastante par rapport à une couleur de la partie textile (3).

4. Ruban textile conducteur selon l'une des revendications précédentes, **caractérisé en ce qu'**il comprend au moins un fil (13) de chaîne de codage, rendu visible ou masqué de façon alternative de manière à créer un code d'identification (17), ce fil de chaîne étant contrastant par rapport à la couleur de la partie textile (3).

5. Ruban textile conducteur selon la revendication 4, **caractérisé en ce que** le code d'identification (17) est constitué d'une série d'un nombre prédéfini de points (19) formés par les parties visibles du fil de chaîne de codage (13).

6. Ruban textile conducteur selon la revendication 5, **caractérisé en ce qu'**au moins une série de points (19) indique un intervalle de conductivité ou résistivité.

7. Ruban textile conducteur selon l'une des revendications 5 et 6, **caractérisé en ce qu'**au moins une série de points (19) indique une information sur une application électrique à laquelle le ruban textile conducteur (1) est destiné.

8. Ruban textile conducteur selon l'une des revendications 4 à 7, **caractérisé en ce que** le fil de chaîne de codage (13) est localisé le long d'un bord latéral (1a) du ruban (1) situé dans la seconde région (B).

9. Ruban textile conducteur selon l'une des revendications 4 à 8, **caractérisé en ce que** le fil de chaîne (13) de codage de couleur contrastante forme un code (17) sur une face (1d) du ruban (1).

10. Ruban textile conducteur selon l'une des revendications précédentes, **caractérisé en ce que** le conducteur (5, 7) comprend une torsade de multi-filaments de cuivre argenté.

11. Ruban textile conducteur selon l'une des revendications précédentes, **caractérisé en ce que** le conducteur électrique (5, 7) forme des boucles (21) ressortant localement et ponctuellement de la partie textile (3) de manière à le rendre accessible hors de la partie textile (3).

12. Ruban textile conducteur selon la revendication 11, **caractérisé en ce qu'**il comprend au moins deux conducteurs électriques (5, 7), et **en ce que** les boucles (21) formées par ces deux conducteurs ressortant de la partie textile (3) sont décalées selon l'axe longitudinal (X).
